# EUROPEAN PATENT APPLICATION

(11) **EP 4 568 054 A1**
(43) Date of publication of application: **11.06.2025**
(21) Application number: 24186763.9
(22) Date of filing: 05.07.2024
(51) Int. Cl.: H02J 7/00, G01R 31/385, G01R 31/392

(54) **BATTERY HEALTH STATE ASSESSMENT METHOD, DEVICE, COMPUTER APPARATUS AND STORAGE MEDIUM**

(30) Priority: 05.12.2023 CN 202311652248
(71) Applicant: Shenzhen Smartsafe Tech Co., Ltd., Shenzhen, Guangdong (CN)
(72) Inventor: LIU, Jun, Shenzhen (CN); ZHAN, Wei, Shenzhen (CN)
(74) Representative: Petraz, Gilberto Luigi

(57) **Abstract**

The embodiments of the present application disclose a battery health state assessment method, including performing discharge control on a cell until a cutoff voltage; performing charge control on the cell according to a preset constant charge power until a preset cell load rated capacity, and performing discharge control on the cell according to a preset constant discharge power until the cutoff voltage, and generating cell discharge efficiency information; performing charge and discharge cycle control on the cell according to the constant charge power and the constant discharge power, and acquiring corresponding charge and discharge cycle control efficiency information; using a cell load algorithm to calculate and generate a cell load actual capacity information based on the cell discharge efficiency information and the charge and discharge cycle control efficiency information; and generating a cell health state assessment information according to the ratio between the cell load actual capacity and the cell load rated capacity. The accuracy of the SOH assessment process can be improved by implementing the methods of the embodiments of the present application to optimize the battery performance assessment process and improve the battery charge and discharge efficiency assessment capability.

## Description

### Technical Field

The present application relates to the technical field of new energy storage, and in particular to a battery health state assessment method, a device, a computer apparatus and a storage medium.

### Background Art

With the global attention to environmental protection and sustainable development, new energy vehicles as an important alternative to traditional fuel vehicles have been widely promoted and applied. As the core energy storage device of new energy vehicles, the performance and safety of power batteries have become one of the important factors affecting industrial development. However, the power battery may be affected by various factors, such as excessive charge and discharge, high temperature, etc. during the long-term use of the power battery, resulting in the decline of battery capacity, safety degradation and even accidents. In order to ensure the safety of batteries and improve the service life, the development of power battery management system (Battery Management System, BMS) becomes one of the indispensable technical means. BMS is primarily responsible for monitoring and managing batteries, where battery State of Health (SOH) is a key indicator for assessing battery life and performance. Accurate calculation of battery SOH is essential for safe and reliable battery management in new energy vehicles and other fields. The performance of SOH is mainly reflected in the decline of battery capacity and the increase of internal resistance. The SOH of a battery reflects the current level of health and performance degradation of the battery, usually judged by measuring battery capacity decline and internal resistance increase. Accurate calculation of battery SOH is essential for battery management and safety in electric vehicles and other fields. By monitoring and assessing the capacity decline and internal resistance increase of the battery, the accuracy of the SOH assessment process can be improved to optimize the battery performance assessment process, improve the battery charge and discharge efficiency assessment capability, and ensure the safety and reliability of electric vehicles.

### Summary of the Invention

Embodiments of the present application provide a battery health state assessment method, device, computer apparatus and storage medium, aiming to solve the problem of poor accuracy of battery health state assessment.

In a first aspect, embodiments of the present application provide a battery health state assessment method, including: starting a cell corresponding to the connection port in the battery assembly by the connection port of the battery equalizer, and performing discharge control on the cell until the cutoff voltage; performing charge control on the cell according to a preset constant charge power until a preset cell load rated capacity, and performing discharge control on the cell according to a preset constant discharge power until the cutoff voltage, and generating cell discharge efficiency information; performing charge and discharge cycle control on the cell according to the constant charge power and the constant discharge power, and acquiring corresponding charge and discharge cycle control efficiency information; using a cell load algorithm to calculate and generate a cell load actual capacity information based on the cell discharge efficiency information and the charge and discharge cycle control efficiency information; and generating a cell health state assessment information according to the ratio between the cell load actual capacity and the cell load rated capacity.

In a second aspect, embodiments of the present application also provide a battery health state assessment device including: a start control unit for starting a cell corresponding to the connection port in the battery assembly by the connection port of the battery equalizer, and performing discharge control on the cell until a cutoff voltage; a discharge control unit for performing charge control on the cell according to a preset constant charge power until a preset cell load rated capacity, and performing discharge control on the cell according to a preset constant discharge power until the cutoff voltage, and generating cell discharge efficiency information; a charge and discharge cycle control unit for performing charge and discharge cycle control on the cell according to the constant charge power and the constant discharge power, and acquiring corresponding charge and discharge cycle control efficiency information; a load capacity information generation unit used for using a cell load algorithm to calculate and generate a cell load actual capacity information based on the cell discharge efficiency information and the charge and discharge cycle control efficiency information; and a state assessment information generation unit for generating a cell health state assessment information according to the ratio between the cell load actual capacity and the cell load rated capacity.

In a third aspect, embodiments of the present application also provide a computer apparatus including a memory and a processor, the memory having stored thereon a computer program, which when executed by the processor implements the method described above.

In a fourth aspect, embodiments of the present application also provide a computer-readable storage medium having stored thereon a computer program including program instructions, which when executed by a processor implement the method described above.

Embodiments of the present application provide a battery health state assessment method, including performing discharge control on a cell until a cutoff voltage; performing charge control on the cell until a preset cell load rated capacity, and performing discharge control on the cell until the cutoff voltage, and generating cell discharge efficiency information; performing charge and discharge cycle control on the cell and acquiring corresponding charge and discharge cycle control efficiency information; using a cell load algorithm to calculate and generate a cell load actual capacity information; and generating a cell health state assessment information according to the ratio between the cell load actual capacity and the cell load rated capacity. The accuracy of the SOH assessment process can be improved by implementing the methods of the embodiments of the present application to optimize the battery performance assessment process and improve the battery charge and discharge efficiency assessment capability.

### Brief Description of the Drawings

In order to more clearly illustrate the technical solutions of the embodiments of the present application, a brief description will be given below of the drawings which need to be used in the description of the embodiments. It is obvious that the drawings in the description below are some embodiments of the present application, and it would have been obvious for a person of ordinary skill in the art to obtain other drawings according to these drawings without involving any inventive effort.
Fig. 1 is a schematic flow diagram of a battery health state assessment method according to an embodiment of the present application;
Fig. 2 is a schematic sub-flow diagram of a battery health state assessment method according to an embodiment of the present application;
Fig. 3 is another schematic sub-flow diagram of a battery health state assessment method according to an embodiment of the present application;
Fig. 4 is yet another schematic sub-flow diagram of a battery health state assessment method according to an embodiment of the present application;
Fig. 5 is further another schematic sub-flow diagram of a battery health state assessment method according to an embodiment of the present application;
Fig. 6 is yet another schematic sub-flow diagram of a battery health state assessment method according to an embodiment of the present application;
Fig. 7 is another schematic sub-flow diagram of a battery health state assessment method according to an embodiment of the present application;
Fig. 8 is a schematic block diagram of a battery health state assessment device provided in an embodiment of the present application; and
Fig. 9 is a schematic block diagram of a computer apparatus according to an embodiment of the present application.

### Detailed Description of the Invention

The technical solutions in the embodiments of the present application will be clearly and completely described below with reference to the drawings in the embodiments of the present application, and it is obvious that the described embodiments are some, but not all, embodiments of the present application. Based on the embodiments of the present application, all other embodiments obtained by a person of ordinary skill in the art without inventive effort fall within the scope of the present application.

It should be understood that when used in the description and appended claims, terms such as "include" and "comprise" indicate the presence of the described features, integers, steps, operations, elements and/or components, but do not exclude the presence or addition of one or more other features, integers, steps, operations, elements, components and/or groups thereof.

It should also be understood that the terms used in the description of the present application are merely for a purpose of describing a specific embodiment, and are not intended to limit the present application. As used in the description and claims of the present application, unless other circumstances are clearly indicated in the context, the singular forms "a/an", "one" and "the" are intended to include the plural form.

It should also be further understood that the term "and/or" used in the description and claims of the present application refers to any combination of one or more of related items and all possible combinations, and includes these combinations.

Embodiments of the present application provide a battery health state assessment method, device, computer apparatus and storage medium.

The execution main body of the battery health state assessment method is a computer apparatus integrated with the battery health state assessment device, wherein the battery health state assessment device can be implemented in hardware or software, such as a battery equalizer applying the above-mentioned assessment method, the battery equalizer has a plurality of connection ports correspondingly connected to a plurality of cells in a battery assembly, and the battery equalizer is controlled by control software in the connected computer apparatus, wherein the computer apparatus can be a terminal or a server, and the terminal can be a tablet computer, a palmtop computer or a notebook computer, etc.

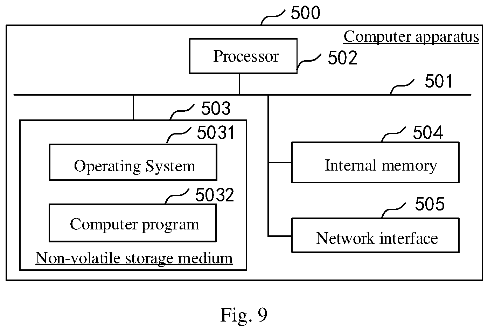

The battery health state assessment method is applied to the computer apparatus 500 in Fig. 9.

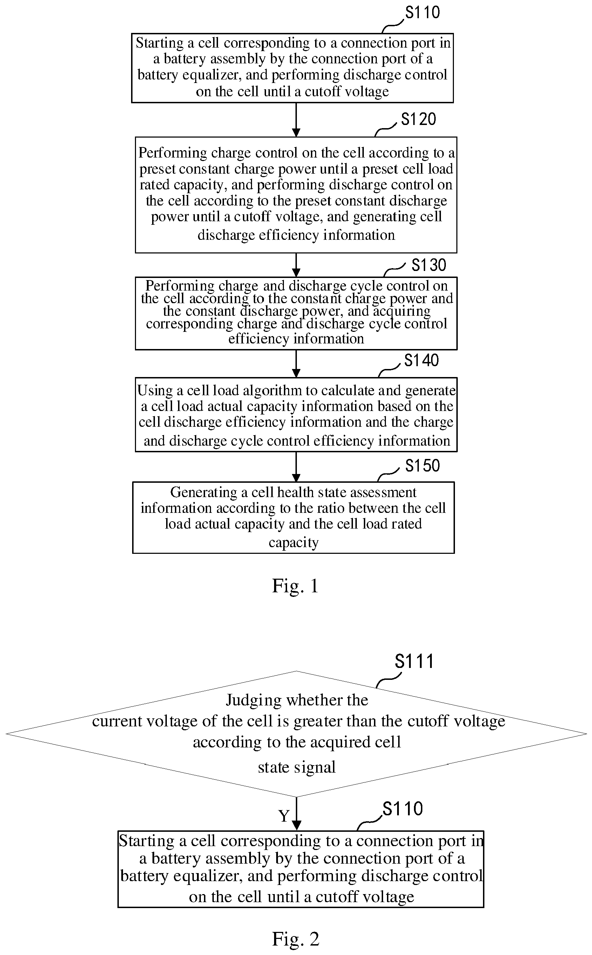

Fig. 1 is a schematic flow diagram of a battery health state assessment method according to an embodiment of the present application. As shown in Fig. 1, the method includes the following steps S110-150.

S110, a cell corresponding to the connection port in the battery assembly is started by the connection port of the battery equalizer, and discharge control is performed on the cell until a cutoff voltage.

Specifically, a cell corresponding to the connection port in the battery assembly could be started by the connection port of the battery equalizer, and discharge control on the cell could be performed until a cutoff voltage. The connection port of the battery equalizer is inserted into the battery assembly at the position corresponding to the connection port. Ensure that the connection is secure and reliable and follow the instructions in the instructions for use of the equalizer. The discharge control of the cell is initiated by the interface or operating button provided by the battery equalizer. The corresponding discharge modes and parameters, such as cutoff voltage, discharge rate, etc. are selected according to the requirements and settings. The battery equalizer will monitor the cell voltage and control according to the set cutoff voltage. Once the cell voltage reaches the set cutoff voltage, the battery equalizer will stop discharging to avoid over-discharging the cell.

S120, charge control on the cell is performed according to a preset constant charge power until a preset cell load rated capacity, and discharge control on the cell is performed according to a preset constant discharge power until the cutoff voltage, and cell discharge efficiency information is generated.

Specifically, the constant charge power is set according to the charge request. Constant charge power represents the level of power that is continuously supplied during charging. Using a charge controller or battery management system, a set constant charge power is applied to the cells. The voltage and current of the cell are monitored, power adjustment is performed according to the set charge power to ensure that the charging is performed at constant power until the preset cell load rated capacity is reached. A constant discharge power is set according to the discharge requirement. Constant discharge power means the power level that is continuously supplied during discharge. Using a discharge controller or battery management system, a set constant discharge power is applied to the cell. The voltage and current of the cell are monitored, power adjustment is performed according to the set discharge power to ensure that the discharging is performed at constant power until the cutoff voltage is reached. Calculation of cell discharge efficiency: according to the energy consumed in the discharge process and the theoretical capacity of the cell, the discharge efficiency of the cell is calculated. The discharge efficiency can be calculated by the following formula: discharge efficiency = actual energy released/theoretical energy released. From the current and time data during discharge, the actual energy released can be calculated.

S 130, charge and discharge cycle control is performed on the cell according to the constant charge power and the constant discharge power, and corresponding charge and discharge cycle control efficiency information is acquired.

Specifically, the constant charge power and the constant discharge power are set according to the charge and discharge requirements. These two parameters represent the power levels continuously supplied during charge and discharge, respectively. Using a charge controller or battery management system, a preset constant charge power is applied to the cell to charge until a preset cell load rated capacity is reached. Using a discharge controller or battery management system, a preset constant discharge power is applied to the cell to discharge until a preset cutoff voltage is reached. Once the charge and discharge process is complete, the next new charge and discharge cycle can begin. Each charge and discharge cycle may last for hours or days, depending on the requirements of the battery and the present application. By monitoring the changes in current and voltage during the charge and discharge cycle, the corresponding charge and discharge cycle control efficiency can be calculated. Charge and discharge cycle control efficiency is generally defined as "energy supplied by charge/energy released by discharge". By using apparatuses such as electronic load or current/voltage sensors, the current and voltage of the battery during charge and discharge can be recorded and the energy value can be calculated. The analysis and assessment are performed based on the calculated charge and discharge cycle control efficiency. If the control efficiency is high, it proves that the battery system has high charge and discharge efficiency and strong battery management capacity; on the contrary, if the control efficiency is low, it is necessary to further optimize the design and management scheme of the battery.

S140, a cell load actual capacity information is calculated and generated by using a cell load algorithm based on the cell discharge efficiency information and the charge and discharge cycle control efficiency information.

Specifically, to calculate and generate the cell actual capacity information, a cell load algorithm may be utilized and calculated based on the cell discharge efficiency and charge and discharge cycle control efficiency information. The initial capacity of the cell needs to be accurately measured before the charge and discharge cycle is performed. This can be determined by reference to cell specifications and technical data, or using standard capacity testing methods. The known cell actual capacity is taken as target value and the constant discharge power is used to make discharge, and the discharge time and discharge capacity are recorded. The discharge efficiency is calculated based on the discharge capacity recorded during discharge and the actual capacity target value. The discharge efficiency may be defined as "actual discharge capacity/target capacity". The cell is restored to the initial state and charged with a constant charge power. The charge time and charge capacity are recorded. The charge efficiency is calculated based on the charge capacity recorded during charge and the actual capacity target value. The charge efficiency may be defined as "actual charge capacity/target capacity". The actual capacity of the cell can be obtained by multiplying both the discharge efficiency and the charge efficiency and then multiplying the result by the initial cell capacity. Actual capacity = initial cell capacity * discharge efficiency * charge efficiency.

S150, a cell health state assessment information is generated according to the ratio between the cell load actual capacity and the cell load rated capacity.

Specifically, from the ratio between the cell load actual capacity and the cell load rated capacity, a cell health state assessment information can be generated as follows. 1. Calculation of capacity loss rate: first, the capacity loss rate of the cell is calculated, and the formula is: capacity loss rate = (1-(actual capacity/rated capacity)) * 100%. 2. Health state assessment: from the value of the capacity loss rate, an assessment of the cell health state can be obtained. In general, the assessment can be divided into the following levels: excellent: the capacity loss rate is between 0% and 5%, indicating that the cell exhibits very good health state with little loss of capacity. Good: the capacity loss rate is between 5% and 20%, indicating that the cell is in good health state and has a small capacity loss. Fair: the capacity loss rate is between 20% and 40%, indicating that the cell health state is general and the capacity loss is obvious, but the basic demand can still be met. Poor: the capacity loss rate is between 40% and 60%, indicating that the cell health state is poor, the capacity loss is severe, the performance begins to decrease, attention for maintenance and replacement is required. Critical: the capacity loss rate exceeds 60%, indicating that the cell health state is seriously decreased, the capacity is seriously insufficient and the use effect has been seriously affected, and the cell shall be immediately maintained or replaced.

In summary, the technical solution has the following advantages: 1. Improved calculation accuracy: by integrating the current using the ampere-hour integration method and considering the influence of the charge efficiency and the discharge efficiency, the degree of capacity loss of the battery can be accurately calculated. This makes it possible to improve the estimation accuracy of the battery SOH (state health) and more accurately assess the capacity condition of the battery. 2. Simplified calculation model: compared to the model-based method, the method does not require the establishment of a complex battery equivalent circuit model. The difficulty of parameter acquisition and computational complexity is reduced. The ampere-hour integral can be calculated only by real-time monitoring and data recording of the current by the equalizer apparatus. Therefore, the method simplifies the computational model and improves the computational efficiency. 3. Improved data collection accuracy: the method can improve the accuracy of data acquisition by real-time monitoring and data recording of the current by the equalizer apparatus. Compared with the traditional method and the model-based method, the method can more accurately acquire the current data in the battery charge and discharge process. This further improves the reliability of the estimation result. In summary, the technical solution has obvious advantages in terms of the calculation accuracy of the battery SOH, the simplification of the calculation model and the accuracy of data collection. This makes the solution more practical and feasible and suitable for various battery management and application scenarios.

The battery health state assessment method disclosed in the present invention can accurately calculate the degree of capacity loss of the battery by integrating the current using the ampere-hour integration method and considering the effects of the charge efficiency and the discharge efficiency, thereby improving the estimation accuracy of the battery state of health. Compared with the traditional model-based method, the method does not need to build complex battery equivalent circuit model, greatly simplifies the calculation model, and reduces the difficulty of parameter acquisition and computational complexity. In addition, the scheme can improve the accuracy of data acquisition through real-time monitoring and data recording of the current by the equalizer apparatus. Compared with the traditional method and the model-based method, the method can more accurately acquire the current data in the battery charge and discharge process, thus improving the reliability of the estimation results. The technical solution has significant advantages, including improving the calculation accuracy, simplifying the calculation model and improving the data collection accuracy. This makes it highly practical and feasible in battery management and application scenarios. The program provides more accurate results for battery state assessment, provides strong support for battery management and optimization, and further promotes the development and application of battery technology.

As shown in Fig. 2, in a more specific embodiment of the present invention, step S111 must also be performed before step 5110 is performed:
S111, whether the current voltage of the cell is greater than a cutoff voltage is judged according to the acquired cell state signal;
The cutoff voltage of the cell refers to the safety cutoff voltage reached by the battery during charge or discharge. The preset cell cutoff voltage is determined according to the characteristics and design requirements of the battery. The cutoff voltage may be different for different types of batteries. The following are preset cutoff voltage ranges for some common battery types: 1. Lithium ion battery (Li-ion): the charge cutoff voltage is usually set at around 4.2V. The discharge cutoff voltage is typically set between 3.0V and 3.3V. 2. Lead acid battery (Lead Acid): the charge cutoff voltage is usually set at 2.35V to 2.40V per unit cell. The discharge cutoff voltage is usually set at 1.75V to 1.80V per unit cell. 3. NiMH battery: the charge cutoff voltage is usually set at 1.45V to 1.55V per unit cell. The discharge cutoff voltage is usually set at 1.0V to 1.1V per unit cell.

If the current voltage of the cell is greater than the cutoff voltage, step 5110 is performed.

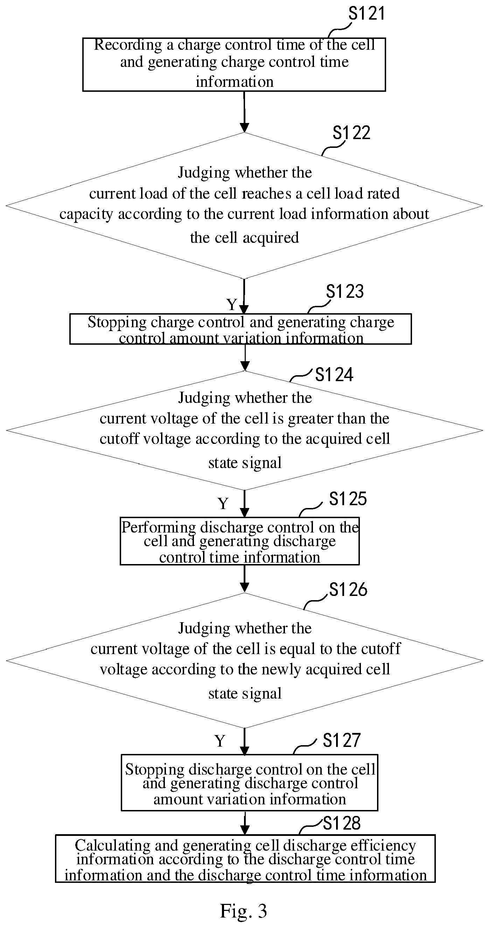

Whether the current voltage of the cell is greater than the cutoff voltage is judged. If the current voltage of the cells is greater than the cutoff voltage, the process proceeds to step S110, in which a plurality of cells in the battery assembly are subjected to equalizing discharge using a battery equalizer. In step S110, a cell to be discharged can be selected by the connection port of the battery equalizer and the equalizing discharge power can be controlled. The purpose of equalizing discharge is to keep the voltage difference between the cells within a small range, to ensure that the states of the individual cells are more equalized, and to discharge the cells to a cutoff voltage to ensure safety. As shown in Fig. 3, executing step S120 also specifically includes executing steps S121-S128: S121, the charge control time for the cell is recorded and charge control time information is generated.

A timer or time stamp function may be provided in the battery charge control system to record the time that the cell is charge controlled and to generate a charge control time information. This may be a software implemented timer or a real time clock (RTC) on a hardware apparatus. Before starting charge control, a timer is started or the current time is recorded as a time stamp. When the cell completes the charge control process, the timer is stopped or the current time is recorded as an end time stamp. The charge control time is calculated based on the start time and the end time. The time interval for charge control may be obtained using a time difference calculation function or method, such as a subtraction operation. A charge control time information is stored in an appropriate data structure, such as a log file, a database, or a variable in memory. The charge control time information may be further processed and analyzed as needed. For example, an average time, a maximum time, a minimum time, etc. of each charge control process may be counted for performance assessment and optimization.

S122, whether the current load of the cell reaches a cell load rated capacity is judged according to the current load information about the cell acquired.

If the current load of the cell reaches the cell load rated capacity, the following steps are perform: S123: the charge control is stopped and charge control amount variation information is generated.

According to the acquired current load information of the cell, judging whether the current load of the cell reaches an upper limit of the cell load, and if the current load is greater than or equal to the upper limit of the cell load, executing step S123; otherwise, other operations or controls are continued. An instruction or signal to stop the charge control is sent to stop the cell from receiving the charging. The charge control amount variation information is recorded and generated, including a time stamp for stopping charging, current and voltage during charge control, etc. The generated charge control amount variation information is stored in an appropriate data structure, such as a log file, a database, or a variable in a memory.

S124, whether the current voltage of the cell is greater than a cutoff voltage is judged according to the acquired cell state signal.

Whether the current voltage of the cell is greater than a cutoff voltage is judged according to the acquired cell state signal; the voltage information of the cell is acquired by using a sensor or monitoring apparatus and is converted into digital signal or voltage value. The cutoff voltage of the cell is determined according to the specifications and design requirements of the specific battery. The cutoff voltage refers to the voltage at which charge or discharge shall be stopped during the charge or discharge of battery, so as to protect the safety and life of battery. The acquired cell voltage is compared with a cutoff voltage. If the cell voltage is greater than the cutoff voltage, indicating that the current voltage of the cell is greater than the cutoff voltage; if the cell voltage is less than or equal to the cutoff voltage, it indicates that the current voltage of the cell is less than or equal to the cutoff voltage.

If the current voltage is greater than the cutoff voltage, step S125 is performed:
5125, discharge control on the cell is performed and discharge control time information is generated. To perform discharge control on the cell and generate discharge control time information: suitable discharge control parameters, such as a discharge current, a discharge cutoff voltage, etc. are determined according to application requirements and cell specifications. These parameters will affect the performance and safety of the cell during discharge. The discharge process of the cell is initiated by controlling an external discharge device, such as a discharge test apparatus or a battery management system, according to the set discharge control parameters. The discharge device is ensured to be correctly connected with the cell, and safety protection measures in the discharge process are paid attention to. During the discharge process, the voltage change of the cell is monitored in real time using a voltage sensor or monitoring apparatus. The acquired voltage data is recorded for subsequent analysis and processing. The real-time monitored cell voltage is compared to the set discharge cutoff voltage. Once the cell voltage reaches or falls below the discharge cutoff voltage, it indicates that the discharge should be stopped. At the end of the discharge process, discharge control time information is recorded according to the actual discharge time. The start time, end time and duration of the entire discharge process can be recorded for subsequent assessment and analysis.

S126, whether the current voltage of the cell is equal to the cutoff voltage is judged according to the newly acquired cell state signal.

Whether the current voltage of the cell is equal to the cutoff voltage is judged according to the newly acquired cell state signal; the voltage information of the cell is acquired by using a sensor or monitoring apparatus and is convert into digital signal or voltage value. The cutoff voltage of the cell is determined according to the specifications and design requirements of the specific battery. The cutoff voltage refers to the voltage at which charge or discharge shall be stopped during the charge or discharge of battery, so as to protect the safety and life of battery.

If the current voltage is equal to the cutoff voltage, step S127 is performed:
S127, discharge control of the cell is stopped and discharge control amount variation information is generated.

To stop discharge control on the cell and generate discharge control amount variation information: according to the current discharge apparatus or system, the operation of stopping discharging is performed. This may involve the steps of shutting down the discharge device, shutting off power, or sending a stop signal. After the discharge was stopped, change information of the discharge control amount was recorded. These variations may include discharge time, discharge capacity, discharge energy, etc. For example, parameters such as the start time and end time of discharge as well as the measured cell voltage and current during discharge are recorded. According to the actual needs, the acquired discharge control amount variation information is processed and analyzed. Discharge duration, discharge capacity loss, energy efficiency, etc. can be calculated to assess the performance of the cell and the effect of discharge control. The processed discharge control amount variation information is recorded and archived for later reference and analysis. Records may be made using spreadsheets, databases, or other means to ensure accuracy and traceability of the data.

S128, the cell discharge efficiency information is calculated and generated according to the discharge control time information and the discharge control time information.

To calculate and generate the cell discharge efficiency information according to the discharge control time information and the discharge capacity information, the following steps can be followed: the discharge start time and end time are recorded. The time information can be used to calculate the discharge duration. The cell capacity at the start and at the end of the discharge was recorded. The capacity information can be used to calculate the discharge capacity loss. The discharge duration is calculated using the discharge start time and the discharge end time. The number of seconds, minutes, or hours that the discharge lasts can be obtained by subtracting the start time from the end time. The discharge capacity loss value is obtained by subtracting the cell capacity at the end from the cell capacity at the start of discharge. The cell discharge efficiency can be calculated by the following formula: discharge efficiency = (discharge capacity loss/actual discharge capacity) * 100%.

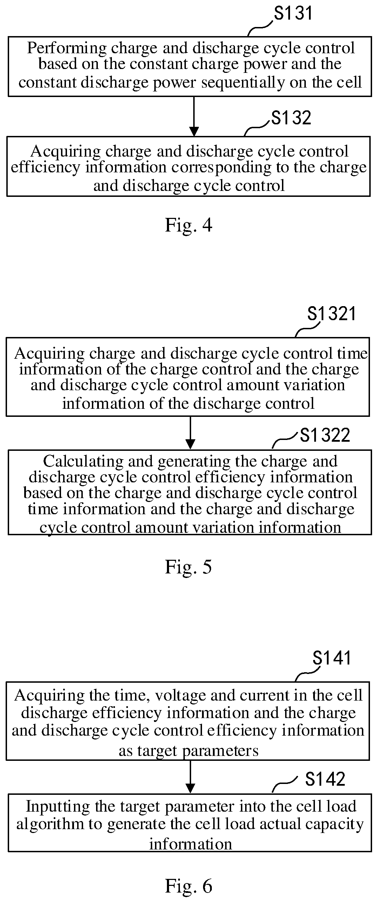

As shown in Fig. 4, executing step S130 also specifically includes executing steps S131-S132:
S131, charge and discharge cycle control based on the constant charge power and the constant discharge power is sequentially performed on the cell, and the charge and discharge cycle control includes the charge control based on the constant charge power and the discharge control based on the constant discharge power.

The charge and discharge cycle control is sequentially performed on the cell based on a constant charge power and a constant discharge power, and a constant charge power and a constant discharge power value are set according to the requirements and specifications of the cell. The cell is connected to a charging source, and charge control based on a constant charge power is performed. The control mode may be to control the charging current or the charging voltage to keep the charge power of the cell constant for a specified time. After the charging is completed, the charging source is disconnected. A discharge control based on a constant discharge power is performed by connecting a cell to a load. The control means may be to control the discharge current or the discharge voltage to keep the discharge power of the cell constant for a specified time. After the discharge is complete, the cell is disconnected from the load. The above steps are repeated to perform charge and discharge cycle control until the preset number of cycles is reached or other stop conditions are met.

S132, charge and discharge cycle control efficiency information corresponding to the charge and discharge cycle control is acquired.

Charge and discharge cycle control efficiency refers to the power conversion efficiency that can be achieved during a charge and discharge cycle. To acquire charge and discharge cycle control efficiency information: the charge efficiency can be calculated by the following formula: charge efficiency = (actual charge capacity/theoretical charge capacity) * 100%. Here, the actual charge capacity refers to the electric energy absorbed by the cell during each charge cycle, and the theoretical charge capacity refers to the expected charge capacity calculated from the charge power and the charge time. Acquiring discharge efficiency: the discharge efficiency can be calculated by the following formula: discharge efficiency = (actual discharge capacity/theoretical discharge capacity) * 100%. The actual discharge capacity refers to the electric energy released by the cell during each discharge cycle, and the theoretical discharge capacity refers to the expected discharge capacity calculated from the discharge power and the discharge time. The average charge and discharge cycle control efficiency can be calculated by summing the charge efficiency and discharge efficiency during each cycle and dividing by the number of cycles.

As shown in Fig. 5, step S132 also specifically includes performing steps S1321-S1322:
S1321, charge and discharge cycle control time information of the charge control and the charge and discharge cycle control amount variation information of the discharge control are acquired.

The charge and discharge cycle control time information of the charge control refers to the duration of each charge cycle, and the charge and discharge cycle control amount variation information of the discharge control refers to the electric quantity change of the cell in each discharge cycle; acquiring charge and discharge cycle control time information of charge control: 1. at the start of each charge cycle, the current time is recorded as the charge start time. 2. After the completion of charging, the current time is recorded as the charge end time. 3. The duration of the charge cycle is calculated as the charge end time minus the charge start time. Acquiring charge and discharge cycle control amount variation information of discharge control: 1. at the start of each discharge cycle, the initial charge of the current cell is recorded. 2. During the discharge process, the electric quantity change of the cell is monitored and recorded, and the real-time monitoring can be performed through the parameters such as voltage or current of the cell. 3. After the discharge is complete, the final charge of the current cell is recorded. 4. The electric quantity change amount of the cell is calculated, i.e. the final charge minus the initial charge.

S1322, charge and discharge cycle control efficiency information is calculated and generated based on the charge and discharge cycle control time information and the charge and discharge cycle control amount variation information.

Based on the charge and discharge cycle control time information and the charge and discharge cycle control amount variation information, charge and discharge cycle control efficiency information can be calculated and generated: 1. the charge efficiency for each charge cycle is calculated using the following formula: charge efficiency = (actual charge capacity/theoretical charge capacity) * 100%. The actual charge capacity is the electric energy absorbed by the cell during each charging cycle, and the theoretical charge capacity can be calculated from the charge power and the charging time. 2. The discharge efficiency was calculated for each discharge cycle using the following formula: discharge efficiency = (actual discharge capacity/theoretical discharge capacity) * 100%. The actual discharge capacity is the electric energy released by the cell during each discharge cycle, and the theoretical discharge capacity can be calculated from the discharge power and the discharge time. The average charge and discharge cycle control efficiency is calculated and the charge efficiency and discharge efficiency for each cycle are summed and divided by the number of cycles. Aiming at the influence of resistance loss and temperature change in practical operation, efficiency correction and control strategy can be optimized to improve cycle control efficiency.

As shown in Fig. 6, in some more specific embodiments of the present invention, performing step S 140 also entails performing steps S 141-142:
S141, time, voltage and current in the cell discharge efficiency information and the charge and discharge cycle control efficiency information are acquired as target parameters.

Acquiring time, voltage and current in the cell discharge efficiency information and the charge and discharge cycle control efficiency information as target parameters: 1. at the start of each discharge cycle, the current time is recorded as the discharge start time. 2. During discharge, the voltage and current information of the cell is monitored and recorded in real time. Sensors or monitoring apparatuses may be used to acquire such data. 3. After the discharge was completed, the current time was recorded as the discharge end time. 4. The duration of the discharge cycle is calculated as the discharge end time minus the discharge start time. 5. Based on the recorded voltage and current information during discharge, the discharge amount of the cell can be calculated. The specific calculation method depends on the characteristics of the cell and the conditions of the discharge process. 6. Calculate the discharge efficiency of the cell using the following formula: discharge efficiency = (actual discharge amount/theoretical discharge amount) * 100%. The actual discharge amount is the electric energy released by the cell during discharge, and the theoretical discharge amount can be calculated according to the current and time. The time, voltage, and current information during each discharge cycle are collated into a data set while recording the corresponding discharge efficiency. For charging cycle control efficiency information, parameters such as time, voltage, and current can be acquired in a similar manner, and charge efficiency can be calculated.

S142, the target parameter is input to the cell load algorithm to generate a cell load actual capacity information.

The target parameter is input to the cell load algorithm, and actual capacity information of the cell can be generated: the capacity variable of the cell is defined with an initial value of zero. The time, voltage, and current information in the target parameters is used to traverse the data for each charge and discharge cycle. For the discharge cycle, the discharge amount in each time interval is calculated from the current and time and added to the capacity variable of the cell. The following formula may be used: discharge amount = current * time interval. For the charge cycle, the charge amount per time interval is calculated from the current and time, and the discharge amount released from the cell is subtracted. The charge amount is added to the capacity variable of the cell. The following formula may be used: charge amount = current * time interval - discharge amount. Continue traversing all charge and discharge cycles, executing steps 3 and 4, until all data has been processed. The finally obtained cell capacity variable is the actual capacity of the cell, and the unit can be determined according to the unit of current and time.

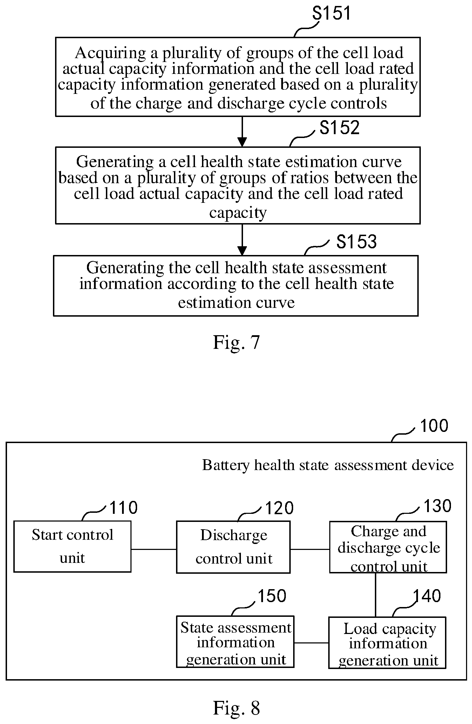

As shown in Fig. 7, in some more specific embodiments of the present invention, performing step S150 also entails performing steps S151-S153:
S151, a plurality of groups of the cell load actual capacity information and the cell load rated capacity information generated based on a plurality of the charge and discharge cycle controls are acquired.

To acquire a plurality of groups of cell load actual capacity information and cell load rated capacity information generated based on a plurality of the charge and discharge cycle controls: charge and discharge cycle control for multiple times are performed, and charge and discharge data of the cell each cycle is recorded, including parameters such as time, voltage and current, etc. According to the cell capacity calculation algorithm mentioned above, the actual capacity of the cell in each cycle is calculated and recorded. The plurality of groups of cell load actual capacity information are obtained. S152, a cell health state estimation curve based on a plurality of groups of ratios between the cell load actual capacity and the cell load rated capacity is generated.

To generate a cell health state estimation curve based on a plurality of groups of ratios between the cell load actual capacity and the cell load rated capacity: a plurality of groups of the cell load actual capacity information and the cell load rated capacity information are set up to ensure consistent data format. For each group of data, the ratio between the cell load actual capacity and the cell load rated capacity is calculated. For example, the ratio = actual capacity/rated capacity. Using the appropriate data visualization tool, the cell health state estimation curve is plotted with ratio as the vertical axis and cycle number or time as the horizontal axis. The display may be in the form of a line graph, a scatter graph, etc. By observing the health state estimation curve, the health state of the cell under different charge and discharge cycles can be found. If the ratio continues to be close to 1, indicating that the actual capacity of the cell is close to the rated capacity, the cell is in good health state. If the ratio decreases gradually, indicating that the cell capacity decays faster, attention may be paid to the use and maintenance of the cell. Further analysis may be performed according to the health state estimation curve, for example, an average ratio, a change trend of the ratio, an abnormal point, and the like are calculated, so as to evaluate the health state of the cell more deeply.

S153, the cell health state assessment information is generated according to the cell health state estimation curve.

The specific method for generating the cell health state assessment information according to the cell health state estimation curve may be as follows: the health state estimation curve is analyzed: the change trend and characteristics of the cell health state estimation curve are observed carefully. The following key points can be noted: stationary region: whether the curve tends to be flat or not, and fluctuates in a relatively stable range is observed. This means that the ratio between the actual capacity of the cell and the rated capacity remains relatively stable and the cell is in good state. Drop Zone: if the curve shows a gradually decreasing trend, indicating that the actual capacity of the cell gradually decreases, there may be a problem of capacity decay, and further attention should be paid to the health state of the cell. Mutation or abnormal point: note whether there are mutations or abnormal points on the curve, which may indicate that the capacity of cell suddenly changes or is affected by abnormal factors, and further investigation is required for the reasons. 2. Assessment based on curve characteristics: combined with the change trend of cell health state estimation curve, the cell health state was assessed. The judgment can be made according to the following aspects: good health state: if the curve fluctuates in the stationary region and remains in a ratio range close to 1 for a longer period of time, it can be assessed that the cell is in a good health state. General health state: if the curve shows a downward trend, but the rate of decline is slow and the ratio is still within the acceptable range, it can be assessed that the cell health state is general. Poor health state: if the curve drops significantly, or even drops sharply, and the ratio is far below the range of rated capacity, it may indicate that the cell is in poor health state and the capacity decays significantly, requiring further attention and maintenance. According to the assessment result, a cell health state assessment information report is generated. Reports may include cell current battery health state ratings, capacity decay, possible cause analysis, and recommended actions for different health states, such as adjusting charge and discharge strategies, optimizing cell management, etc.

Fig. 8 is a schematic block diagram of a battery health state assessment device provided in an embodiment of the present application. As shown, the present application also provides a battery health state assessment device 100 corresponding to the above battery health state assessment method. The battery health state assessment device includes a unit for executing the battery health state assessment method described above, and may be configured in a terminal such as a desktop computer, a tablet computer, a laptop computer, etc. Specifically, referring to Fig. 8, the battery health state assessment device 100 includes a start control unit 110, a discharge control unit 120, a charge and discharge cycle control unit 130, a load capacity information generation unit 140, and a state assessment information generation unit 150.

110, A start control unit for starting a cell corresponding to the connection port in the battery assembly by the connection port of the battery equalizer, and performing discharge control on the cell until a cutoff voltage;
120, A discharge control unit for performing charge control on the cell according to a preset constant charge power until a preset cell load rated capacity, and performing discharge control on the cell according to a preset constant discharge power until the cutoff voltage, and generating cell discharge efficiency information;
130, A charge and discharge cycle control unit for performing charge and discharge cycle control on the cell according to the constant charge power and the constant discharge power, and acquiring corresponding charge and discharge cycle control efficiency information;
140, A load capacity information generation unit used for using a cell load algorithm to calculate and generate a cell load actual capacity information based on the cell discharge efficiency information and the charge and discharge cycle control efficiency information;
150, A state assessment information generation unit for generating a cell health state assessment information according to the ratio between the cell load actual capacity and the cell load rated capacity.

It should be noted that the specific implementation of the battery health state assessment device and the units described above can be clearly understood by those skilled in the art with reference to the corresponding description of the embodiments of the method described above, and will not be described in detail herein for the sake of convenience and brevity.

The battery health state assessment device described above may be implemented in the form of a computer program which may be run on a computer apparatus as shown in Fig. 9.

Reference is now made to Fig. 9, which is a schematic block diagram of a computer apparatus according to an embodiment of the present application. The computer apparatus 500 may be a terminal or a server, wherein the terminal may be an electronic apparatus having a communication function such as a tablet computer, a notebook computer, and a desktop computer. The server may be an independent server or a server cluster composed of a plurality of servers.

Referring to Fig. 9, the computer apparatus 500 includes a processor 502, a memory, which may include a non-volatile storage medium 503 and an internal memory 504, and a network interface 505 connected via a system bus 501.

The non-volatile storage medium 503 may store an operating system 5031 and a computer program 5032. The computer program 5032 includes program instructions that, when executed, cause the processor 502 to perform a battery health state assessment method.

Although only the specific embodiments of the present application have been described above, the scope of protection of the present application is not limited thereto, and any person skilled in the art can easily conceive various equivalent modifications or substitutions within the technical scope disclosed in the present application, and these modifications or substitutions should be covered by the scope of protection of the present application. Accordingly, the protection sought herein is as set forth in the claims below.

## Claims

1. A battery health state assessment method applied to a battery equalizer, a plurality of connection ports of the battery equalizer correspondingly connecting a plurality of cells in a battery assembly to perform charge and discharge control on the battery assembly, **characterized by** comprising:
starting a cell corresponding to the connection port in the battery assembly by the connection port of the battery equalizer, and performing discharge control on the cell until a cutoff voltage;
performing charge control on the cell according to a preset constant charge power until a preset cell load rated capacity, and performing discharge control on the cell according to a preset constant discharge power until the cutoff voltage, and generating cell discharge efficiency information;
performing charge and discharge cycle control on the cell according to the constant charge power and the constant discharge power, and acquiring corresponding charge and discharge cycle control efficiency information;
using a cell load algorithm to calculate and generate a cell load actual capacity information based on the cell discharge efficiency information and the charge and discharge cycle control efficiency information; and
generating a cell health state assessment information according to the ratio between the cell load actual capacity and the cell load rated capacity.

2. The battery health state assessment method according to claim 1, **characterized in that** before starting the cell in the battery assembly corresponding to the connection port by the connection port of the battery equalizer, further comprises:
judging whether the current voltage of the cell is greater than a preset cutoff voltage according to the acquired cell state signal; and
if the current voltage is greater than the cutoff voltage, executing the step of starting the cell in the battery assembly corresponding to the connection port by the connection port of the battery equalizer.

3. The battery health state assessment method according to claim 2, **characterized in that** the generating cell discharge efficiency information comprises:
recording a charge control time for the cell and generating charge control time information;
judging whether the current load of the cell reaches a cell load rated capacity according to the current load information about the acquired cell;
stopping charge control and generating charge control amount variation information if the current load of the cell reaches the cell load rated capacity;
judging whether the current voltage of the cell is greater than the cutoff voltage according to the acquired cell state signal;
performing discharge control on the cell and generating discharge control time information if the current voltage is greater than the cutoff voltage;
judging whether the current voltage of the cell is equal to the cutoff voltage according to the newly acquired cell state signal;
stopping discharge control on the cell and generating discharge control amount variation information if the current voltage is equal to the cutoff voltage; and
calculating and generating the cell discharge efficiency information according to the discharge control time information and the discharge control time information.

4. The battery health state assessment method according to claim 3, **characterized in that** the performing charge and discharge cycle control on the cell according to the constant charge power and the constant discharge power, and acquiring corresponding charge and discharge cycle control efficiency information, comprises:
performing charge and discharge cycle control based on the constant charge power and the constant discharge power sequentially on the cell, the charge and discharge cycle control comprising the charge control based on the constant charge power and the discharge control based on the constant discharge power; and
acquiring charge and discharge cycle control efficiency information corresponding to the charge and discharge cycle control.

5. The battery health state assessment method according to claim 4, **characterized in that** the acquiring charge and discharge cycle control efficiency information corresponding to the charge and discharge cycle control, comprises:
acquiring charge and discharge cycle control time information of the charge control and charge and discharge cycle control amount variation information of the discharge control; and
calculating and generating the charge and discharge cycle control efficiency information based on the charge and discharge cycle control time information and the charge and discharge cycle control amount variation information.

6. The battery health state assessment method according to claim 5, **characterized in that** the using a cell load algorithm to calculate and generate a cell load actual capacity information based on the cell discharge efficiency information and the charge and discharge cycle control efficiency information, comprises:
acquiring time, voltage and current in the cell discharge efficiency information and the charge and discharge cycle control efficiency information as target parameters; and
inputting the target parameter into the cell load algorithm to generate the cell load actual capacity information.

7. The battery health state assessment method according to claim 6, **characterized in that** the generating a cell health state assessment information according to the ratio between the cell load actual capacity and the cell load rated capacity, comprises:
acquiring a plurality of groups of the cell load actual capacity information and the cell load rated capacity information generated based on a plurality of the charge and discharge cycle controls;
generating a cell health state estimation curve based on a plurality of groups of ratios between the cell load actual capacity and the cell load rated capacity; and
generating the cell health state assessment information according to the cell health state estimation curve.

8. A battery health state assessment device, **characterized by** comprising:
a start control unit for starting a cell corresponding to the connection port in the battery assembly by the connection port of the battery equalizer, and performing discharge control on the cell until a cutoff voltage;
a discharge control unit for performing charge control on the cell according to a preset constant charge power until a preset cell load rated capacity, and performing discharge control on the cell according to a preset constant discharge power until the cutoff voltage, and generating cell discharge efficiency information;
a charge and discharge cycle control unit for performing charge and discharge cycle control on the cell according to the constant charge power and the constant discharge power, and acquiring corresponding charge and discharge cycle control efficiency information;
a load capacity information generation unit for using a cell load algorithm to calculate and generate a cell load actual capacity information based on the cell discharge efficiency information and the charge and discharge cycle control efficiency information; and
a state assessment information generation unit for generating a cell health state assessment information according to the ratio between the cell load actual capacity and the cell load rated capacity.

9. A computer apparatus, **characterized by** comprising a memory and a processor, the memory having stored thereon a computer program, which when executed by the processor implements the method according to any one of claims 1-7.

10. A computer-readable storage medium, having stored thereon a computer program comprising program instructions, which when executed by a processor implement the method according to any one of claims 1-7.
